# EUROPEAN PATENT APPLICATION

(11) **EP 1 119 103 A1**
(43) Date of publication of application: **25.07.2001**
(21) Application number: 00300386.0
(22) Date of filing: 19.01.2000
(51) Int. Cl.: H03K 5/19, G01R 31/28

(54) **Clock signal supply**

(71) Applicant: LUCENT TECHNOLOGIES INC., Murray Hill, New Jersey 07974-0636 (US)
(72) Inventor: Falaki, Hamid Reza, Swindon, Wiltshire SN5 5AA (GB); Hussain, Nayyar, Swindon, Wiltshire SN5 9FG (GB); Pereira, Robin Leonard, Swindon, Wiltshire SN4 8HH (GB); Taylor, Neil Dean, Marlborough, Wiltshire SN8 1TS (GB)
(74) Representative: Williams, David John

(57) **Abstract**

A clock signal monitor is described having a detector (24-34) responsive to a radio frequency input clock signal to provide a detected signal representative of the amplitude of the input signal. A threshold detector (36, 38, 40) detects whether or not the detected signal represents an amplitude below a threshold. A sounder (42) gives an alarm indication if amplitude below the threshold is detected.

If the laboratory reference clock signal becomes weak or fails the alarm indication is given. Equipment's internal reference clock signal generator is generally sufficiently accurate that if incorrectly configured equipment is connected to the laboratory supply, resulting in amplitude modulation of the signal, the beat frequency would normally be around 1Hz. An intermittent alarm indication is thus given at the same frequency as the amplitude of the modulated signal falls below the threshold.

## Description

This invention relates to clock signal supplies.

Much modern electrical equipment requires a reference clock signal. In, for example, development laboratories newly designed equipment needs to be tested, sometimes over long periods. Many of the tests are automated and may run for months. If the reference clock signal is interrupted or corrupted, the results of the tests are not valid. This may go unnoticed. Some equipment is configurable to use an internal reference clock signal or an external reference clock signal. The input port for an external reference clock signal can also serve as an output to other equipment if the equipment is configured to use an internal reference clock signal. A development laboratory commonly has a common reference clock signal generator which is supplied over a distribution network to outlets on many benches. If equipment is connected to the laboratory reference clock signal generator and has not been correctly configured, the equipment's internal reference clock signal is put on the laboratory supply as well as the signal from the laboratory signal generator. The two signals will not be exactly synchronised resulting in amplitude modulation at a beat frequency, which invalidates whatever testes are being run.

Against this background, in accordance with the invention there is provided clock signal generator in combination with a monitor, comprising: a detector responsive to a radio frequency input signal to provide a detected signal representative of the amplitude of the input signal; a threshold detector for detecting whether or not the detected signal represents an amplitude below a threshold; and means for giving an alarm indication if amplitude below the threshold is detected.

If the laboratory reference clock signal becomes weak or fails, the alarm indication is given. Equipment's internal reference clock signal generator is generally sufficiently accurate that if incorrectly configured equipment is connected to the laboratory supply, resulting in amplitude modulation of the signal, the beat frequency would normally be around 1Hz. An intermittent alarm indication is thus given at that frequency as the amplitude of the modulated signal falls below the threshold. The clock signal generator may generate an original clock signal or may recover it, for example, from broadcast radio transmissions.

In the preferred case of the means for giving an alarm indication including a sounder, an audible tone will beep intermittently at the beat frequency.

The means for giving an alarm indication may also or alternatively include means for giving a visible indication.

The invention also extends to a laboratory clock signal supply, having a plurality of outlets for clock signals, and the combination of a monitor and a clock signal generator, in accordance with the invention, to supply clock signals to the outlets.

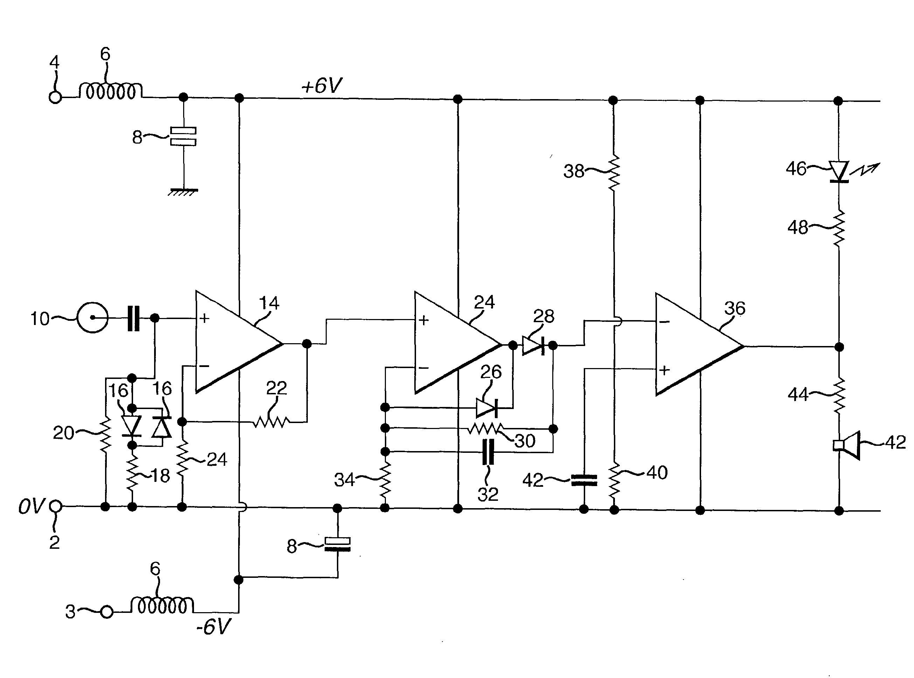

One embodiment of the invention will now be described, by way of example, with reference to the accompanying drawing, which is a circuit diagram of a reference clock signal monitor embodying the invention.

Power supplied to the circuit at terminals 2,3 and 4 is smoothed by a serial inductors 6 and parallel capacitors 8 to provide +6v, 0v and -6v rails. A radio frequency reference clock signal to be monitored is supplied to an input connector 10. The frequency may, for example, be 10MHz. The input signal is passed via a capacitor 12 to a non-inverting input of an amplifier 14. Over-voltage protection is provided by parallel back-to-back diodes 16 in series with a resistor 18 and parallel resistor. The gain of the amplifier 14 is set by a feedback resistor 22 connected between an output and an inverting input, and a resistor 24 connected between the inverting input and the 0v rail.

The amplified clock signal is passed to a non-inverting input of another amplifier 24. Diodes 26 and 28 are arranged in a feedback path to an inverting input and in a forward path at the output so that a full wave rectified signal is output from the diode 28. This is fed back to the inverting input via a parallel resistor 30 and capacitor 32. A resistor 34 is connected between the inverting input and the 0v rail so that the amplifier acts as a leaky integrator producing an amplitude detected signal at its output.

The detected signal is passed to one input of a comparator 36. The other input has a reference voltage input set by resistors 38 and 40, and smoothed by a capacitor 42. The output of the comparator drives two indicators. One is a sounder 42 in series with a resistor 44. The other is an LED 46 in series with a resistor 48.

When the detected signal exceeds a threshold set by the reference voltage input to the comparator 36, the output of the comparator is -6v and the LED is illuminated. There is no voltage across the sounder which is thus silent.

If the clock signal input is weak, the detected signal input to the comparator falls below the threshold and the output of the comparator 36 goes to + 6v. This extinguishes the LED, giving an alarm indication. A further alarm indication is given by the operation of the sounder.

If unconfigured equipment is attached to the clock supply so that both the laboratory clock and the equipment's internal clock are both present on the laboratory clock distribution network, the signals sum and produce a wave amplitude modulated at a beat frequency equal to the difference between the two clock signals. That would normally be only a cycle or two per second so that intermittent operation of the sounder and LED is produced.

In the event of an alarm condition, the type of fault can be identified from the alarm. If it is continuous, the reference clock signal is either weak or absent, i.e. there is a problem with the laboratory signal generator or the distribution network. If the alarm indication is intermittent, the problem is wrongly configured equipment. In the latter case, the alarm will sound immediately the equipment is connected to the distribution network, so that the person who connected the equipment will know their equipment caused the problem. Previously, because the problem might not be discovered for some time, it was difficult to identify which equipment was causing the problem.

## Claims

1. A clock signal generator in combination with a monitor, comprising: a detector (24-34) responsive to a radio frequency input signal to provide a detected signal representative of the amplitude of the input signal; a threshold circuit (36,38,40) for detecting whether or not the detected signal represents an amplitude below a threshold; and means (42 ,46) for giving an alarm indication if amplitude below the threshold is detected.

2. A combination as claimed in claim 1, wherein the means (42) for giving an alarm indication includes a sounder.

3. A combination as claimed in claim 1 or 2, wherein the means (42,46) for giving an alarm indication includes means for giving a visible indication.

4. A laboratory clock signal supply, having a plurality of outlets for clock signals, and the combination of a monitor and a clock signal generator, as claimed in any preceding claim, to supply clock signals to the outlets.
